# EUROPEAN PATENT SPECIFICATION

(11) **EP 0 990 281 B1**
(45) Date of publication and mention of the grant of the patent: **19.03.2003**
(21) Application number: 98923201.2
(22) Date of filing: 12.05.1998
(51) Int. Cl.: H01R 43/20, H05K 13/04

(54) **DEVICE FOR PRE-POSITIONING COMPONENTS IN A ROW FOR SUBSEQUENT PROCESSING AS WELL AS SUCH A METHOD**
VORRICHTUNG ZUR VORPOSITIONIERUNG VON BAUELEMENTEN ZU EINER REIHE ZUR WEITERVERARBEITUNG UND VERFAHREN DAFÜR
DISPOSITIF DE PREPOSITIONNEMENT DE COMPOSANTS EN RANGEE EN VUE D'UN TRAITEMENT ULTERIEUR ET PROCEDE CONNEXE

(30) Priority: 19.06.1997 US 50251 P
(43) Date of publication of application: 05.04.2000
(73) Proprietor: FCI, 75009 Paris (FR)
(72) Inventor: VAN DEN AKER, Cornelis, Gualtherus, Josephus, NL-5253 BB Nieuwkuijk (NL)
(74) Representative: de Vries, Johannes Hendrik Fokke
(86) International application number: NL9800263
(87) International publication number: WO98058428

(56) References cited:
- US-A- 4 386 464
- US-A- 4 451 324
- US-A- 4 528 747
- US-A- 5 639 203

## Description

The invention relates to a device for pre-positioning components in a row at predetermined positions for subsequent processing.

The invention also relates to a method for pre-positioning components in a row for subsequent processing.

This invention relates to pre-positioning of components for mechanical or robotic pick-up and for subsequent processing like insertion into a printed circuit board, die stamping, molding, assembly or plating. It has particular applicability to application equipment for placing and inserting electrical connectors onto printed circuit boards, especially by means of the connector application equipment disclosed in WO 98/58527, which is herein incorporated by reference.

The objective of said above-identified application equipment is to locate accurately several connector modules on a tool, subsequently accurately measure the true-position of press-fit tails as related to a tooling index point and accurately position this assembly with the measured true-position of board holes prior to press-fit application of the connector modules in a single application step.

However, to reduce the time necessary for fitting of the connector modules to the tool, such modules need to be removed from the tube-unloader or other product source and positioned for subsequent pick-up by the tool.

For efficient production, the swiftness and accuracy of product placement is important. Often with products, such as modular connectors, that are end-to-end stackable, customer requirements dictate arrangements of several such connector modules being placed adjacent to each other. Also, some customers dictate placement of, for example, two such modules adjacent to each other, followed by an air gap of 1 mm, e.g., to insert metal shield plates, to be followed by another two adjacently located modules. In some applications, this gap may be larger, to locate such products on either side of a component, for example a transformer, previously located on the printed circuit board.

In all of these situations, the programmed placement needs to be accurate and without application of extraneous forces that might result in damage or loss in production. Surface mount placement devices have some of these capabilities. These devices have three degrees of movement being horizontal, vertical and rotation, with a placement accuracy of ± 0,1 mm. However, such units are very costly. Consequently, a less expensive positioning means is desirable.

If components which need to be placed end to end on the printed circuit board are pre-positioned in a row, problems occur when one component must be located between two components which are already located at their predetermined positions in the row. Because the space between these components (for example 12 mm) is nearly the same as the dimension (for example 11,8 mm) of the component to be placed therebetween, the tool mounting the component in the row must be very accurate to avoid damaging of the components. By the known devices the accurate mounting results in a relatively slow mounting of the component in the rows.

The object of the invention is to provide a device whereby components can be pre-positioned on a predetermined position in a row in a relatively fast and accurate manner.

This objective is achieved by the device according to the invention in that the device comprising at least one template having several component receiving segments lying at said predetermined positions on a row which segments are moveable with respect to the template and each other in at least one direction parallel to said row, whilst furthermore the device comprises at least one component mounting tool to pre-position a component on an empty segment, which tool comprises means to relatively move the segments adjacent to said empty segment temporarily in a direction away from said empty segments.

Because the segments on which the components are mounted can be moved away from the empty segment, the space to mount the component becomes relatively large and the accuracy of the tool can be relatively low. The segment on which the component needs to be placed is being aligned with respect to the tool by movement of the segment by the tool. Therefore the accuracy by which the component is put on the segment is still very high. After removal of the tool, the segments return to their predetermined initial positions in which the distance between adjacent components can be very small.

The invention also relates to a method for pre-positioning components in a row at predetermined positions for subsequent processing. This method is characterized in that the components are positioned on segments lying at said predetermined positions on a row, whereby to mount a component on an empty segment, the adjacent segments together with the components already mounted thereon are relatively moved away from the empty segments against spring force and after mounting of the component on the empty segment and before subsequent processing of said row of components, the adjacent segments are moved back to their initial predetermined position.

Due to this method components can be pre-positioned in a efficient and accurate manner.

It has to be noted that from US-A-5.639.203 a device and method is known whereby a first pick-up picks up several components which are placed simultaneously on setting blocks. Then the setting blocks are moved apart to make the spacings identical to the component spacings required at the board. By the device and method according to the invention the component receiving segments are lying at predetermined positions or at the desired spacings before and after placing a component on an empty segment. Only during the placing of a component on said empty segment, the segments adjacent to said empty segment are temporarily moved aside.

Due to this method components can be pre-positioned in a efficient and accurate manner.

### Brief description of the drawings

Fig. 1 is a top view of a product configuration unit.
Fig. 2 is an end view of a product configuration unit.
Fig. 3 is a side view of the product configuration unit shown in fig. 1.
Fig. 4 is a top view of the product configuration unit shown in fig. 2, partially disassembled.
Figs. 5a and 5b are plan views of segments of a conveyor used in the equipment depicted in figs. 1 and 2.
Figs. 6a, 6b and 6c are plan views of individual parts in unassembled and assembled views of the conveyor sections shown in figs. 3a and 3b.
Figs. 7a and 7b are front and side views, respectively, of a product locating tool for locating connectors on a conveyor of the structure shown in figs. 5a, 5b and 6a, 6b and 6c.
Fig. 8 is an isometric view of a product positioning tool as shown in figs. 5a and 5b cooperating to place parts on a conveyor.
Fig. 9a is a top view of three adjacent plates of the conveyor with the middle position being empty.
Fig. 9b is essentially the same view as fig. 9a, with the middle position loaded with product.
Fig. 10a shows a top view of a second embodiment of a product configuration unit according to the invention.
Fig. 10b shows a side view of the product configuration unit as shown in fig. 10a along lines XB-XB.
Fig. 10c is an enlarged detail indicated by XC of the product configuration unit as shown in fig. 10b.
Fig. 10d is an enlarged detail indicated by XD of the product configuration unit as shown in fig. 10a.
Fig. 11 shows a cross section of the product configuration unit as shown in fig. 10a along lines XI-XI.
Fig. 12a shows a top view of two segments of the product configuration unit as shown in fig. 10a.
Fig. 12b shows a side view of the segment as shown in fig. 12a.
Figs. 13a en 13c shows on a top view of two segments of the product configuration unit as shown in fig. 10a respectively in the initial position and the position in which a component may be placed.
Figs. 13b and 13d show enlarged views of fig. 13a and fig. 13c respectively.

Like parts are numbered alike in the figures.

### Description of preferred embodiments

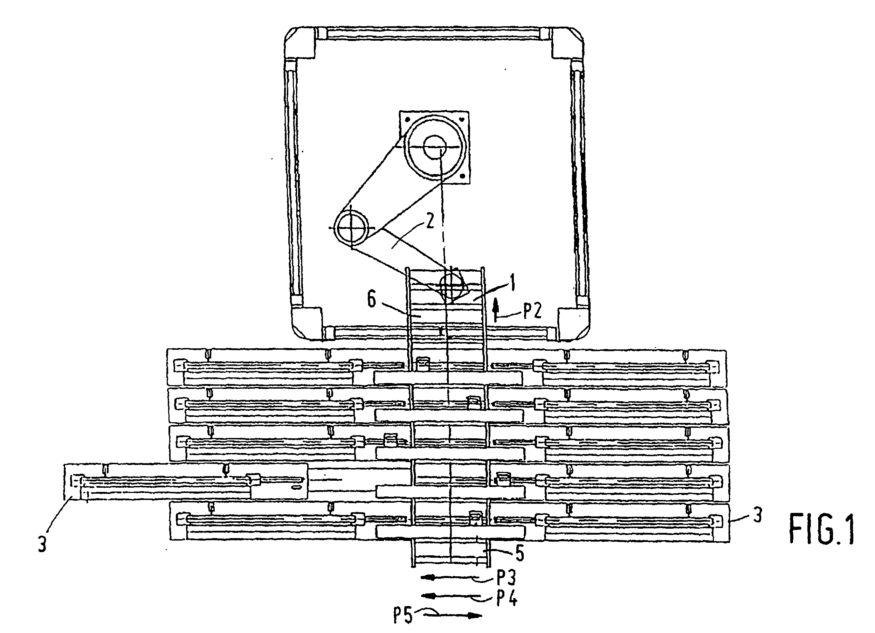

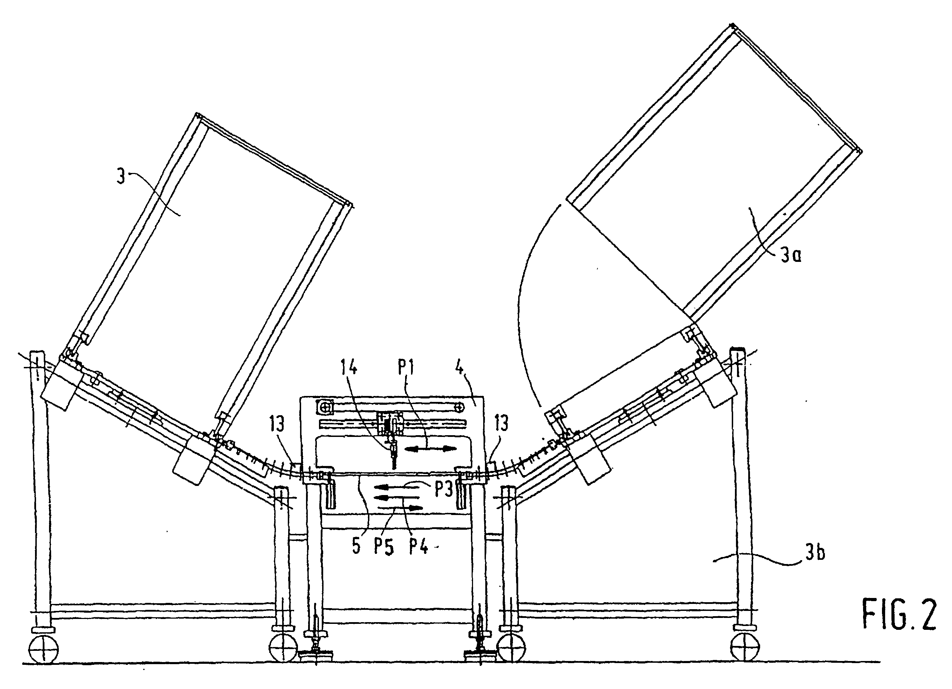

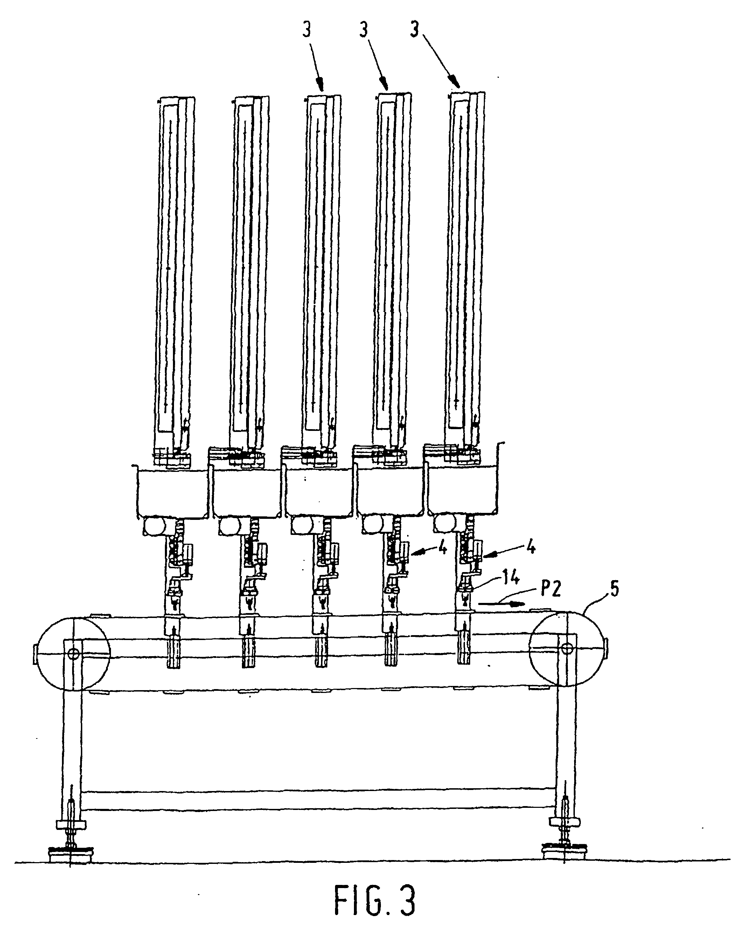

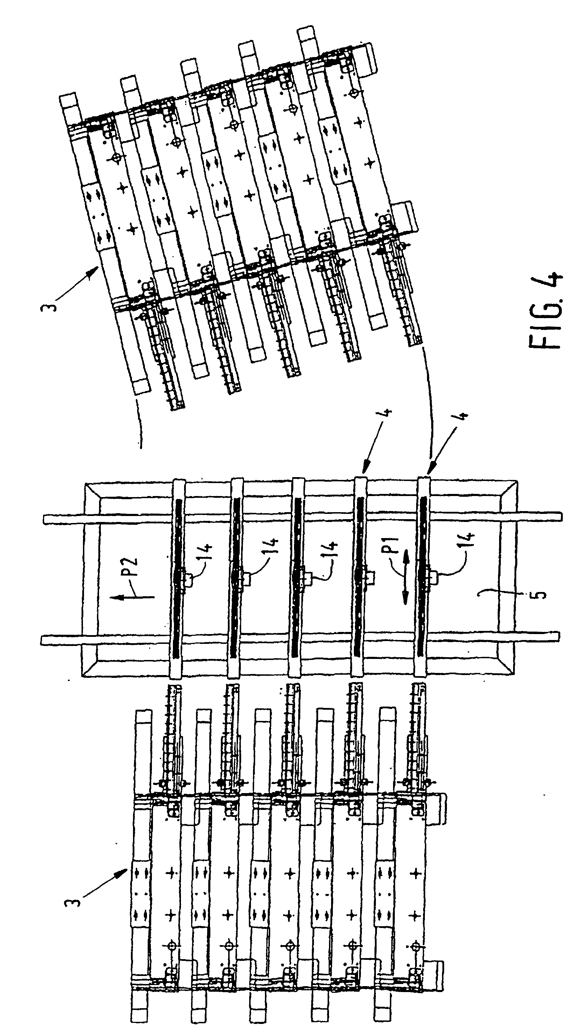

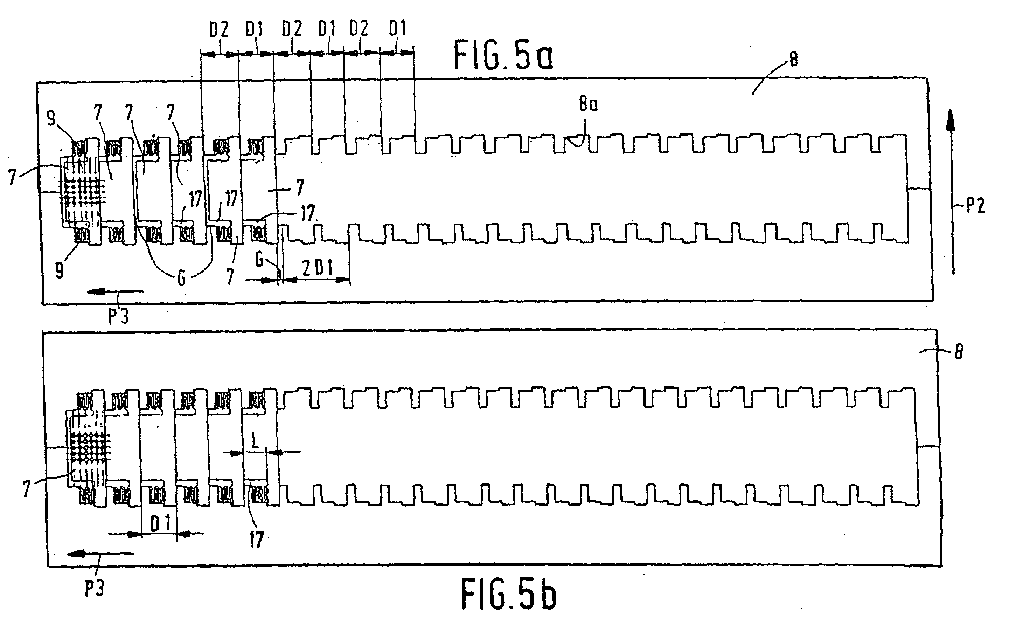

Figs. 1-4 show the product configuration station C located adjacent to pick-up tooling head 1 attached to a robot arm 2. The tooling head 1 releasably holds reusable tools (not shown) on which are received one or more connector modules. The tools are of a type for locating and inserting press-fit connector modules 13 into a printed circuit board according to the method for example as described in the above-mentioned WO98/58527. The connector modules 13 are located in an orientated fashion at the end of tube unloaders 3 on either side of a centrally located conveyor 5. A placer 4 has the function to pick up a connector module 13 at the end of the tube unloader and locate these modules at a programmed location in one of the segments 7 of the templates 8 (see fig. 5a, 5b) of the conveyor 5. The tube unloader units 3 comprise a magazine 3a of tubes for containing product and a movable rack unit 3b. Fig. 4 shows a right hand unloader unit 3 about to be positioned along side conveyor 5. The placer 4 comprises a positioning tool 14 movable in directions indicated by double arrow P1 transversely across the conveyor 5 and vertically toward and away from the conveyor 5. A product placer 4 may be associated with each tube unloading station 3. The sequence of the product placer 4 is pre-programmed for each product. By appropriate programming, a different array of connector modules 13 can be assembled across the conveyor 5. The conveyor 5 is program indexed in a direction indicated by arrow P2 from the first tube unloading station to the next, finally delivering all products located in one of the templates 8 at the end station 6, where a tool mounted in tooling head 1 of robot arm 2 is loaded with the assembled row of connector modules 13 from the template 8.

### Template/segment build-up

Figs. 5a and 5b illustrate a template 8 of the conveyor 5, the conveyor 5 being formed of a plurality of templates 8 jointed together preferable to form an endless loop, and moved in the direction of arrow P2. The configuration in fig. 5b is the standard configuration, in which several straight modules, for example, plug connectors, can be positioned adjacent to each other at a pitch of D1, for example of 12 mm. The configuration of fig. 5a is used for a product configuration in which two modules with a width of D1 are located adjacent to each other, followed by an air-gap space G of 1 mm, to be followed by another group of two modules. Each module is for example 12 mm wide (= D1) whilst the distance D2 between one module of one group to the first module of the next group is 13 mm (D2 = D1 + G). Several individually, transversely movable segments 7 are located in a template 8 over the width of the conveyor 5. The recessed sides 8a of the template are accurately ground along a special contour. In each of figs. 5a and 5b, only the first six segments 7 are shown for purposes of drawing simplicity. As previously noted, the templates 8 of conveyor 5 advance stepwise to end station 6 in the direction of arrow P2.

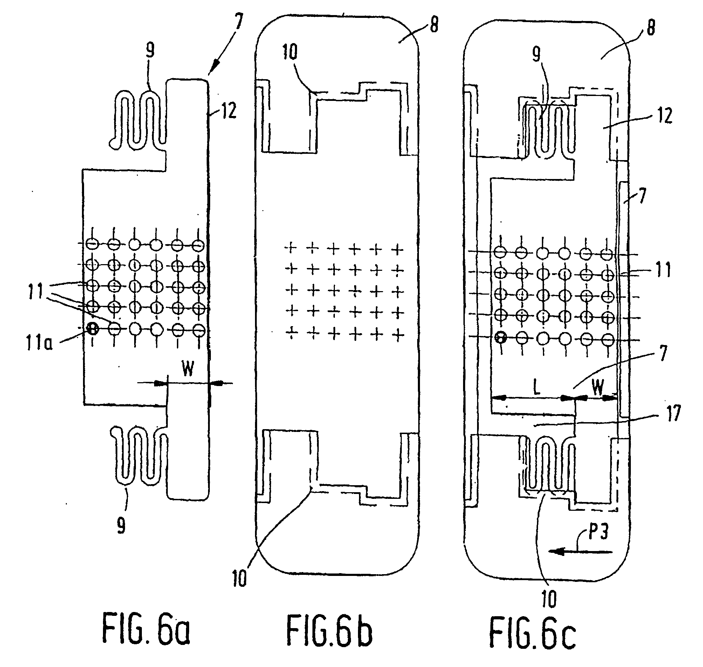

Fig. 6a shows a segment 7. Each segment 7 has two spring members 9 located at each end of a base portion 12. As shown in fig. 6a, each segment 7 has an array of holes 11, the diameter of which is slightly larger than the outer periphery of the press-fit pins of the connector module 13, as depicted by hole 11a. The configuration of the holes 11 is governed by the pin configuration of the connector module 13. For example, the segment 7 can be for a 4 or 5 row product, in which case the segment will have five rows of holes as standard.

Fig. 6b shows opposed portions of the contour 8a for receiving one of the segments 7. The template 8 has recessed zones 10 preventing the segments 7 from falling out of the template. Outside edge portions of the base portion 12 and springs 9 are slidably received in the recesses 10 of the template 8 to allow transverse movement in the direction of arrow P3 of the segment with respect to the template 8. Fig. 6c shows the segment 7 with such edges received in the recessed zones 10.

The recessed zone 10 can be formed by machining or by clamping two plates together to form the recessed area. The template 8 can be molded plastic or machined or stamped metal. The springs 9 may be integrally insert molded in a plastic segment 7 or the segment 7 may be stamped or molded unitary element of plastic or metal.

### Position tooling/segment operation

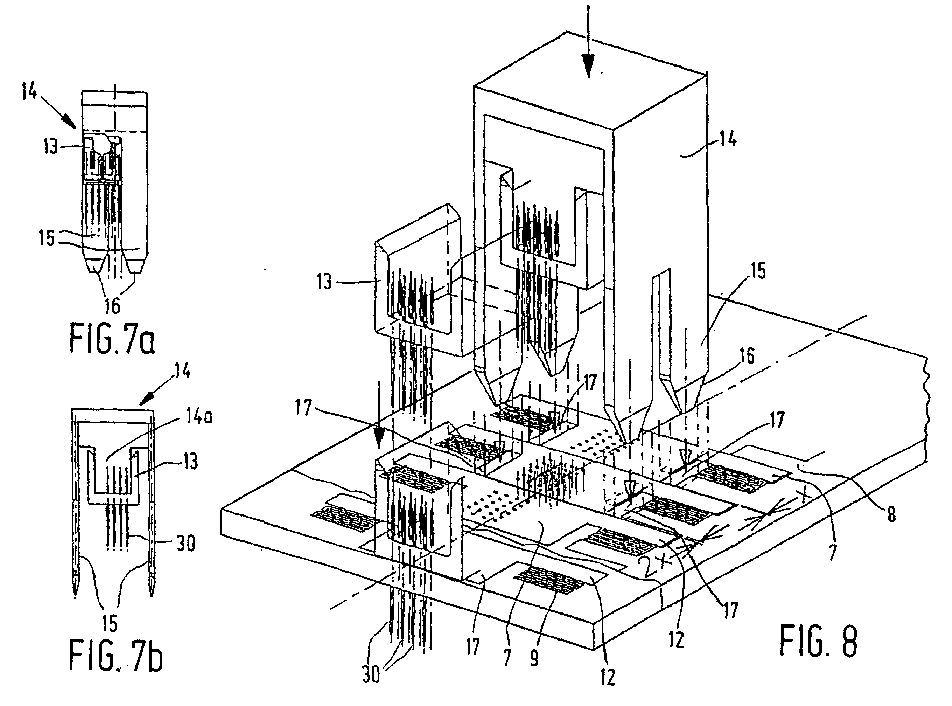

Figs. 7a and 7b show front and side views of the position tool 14 which has a contoured gripping section 14a to fit the product 13 being placed. Such a position tool 14 is connected to the product placer 4 shown in figs. 1-3 to pick up and locate a connector module 13 in one segment 7 on the template 8 of conveyor 5.

As shown in the figs. 7a, 7b and 8, the positioning tool 14 has four legs 15 of a specific width and thickness. The distal portion of each leg 15 has a lead-in nose 16 to pre-position and accurately enter a recess 17 positioned opposite to it in the template 8.

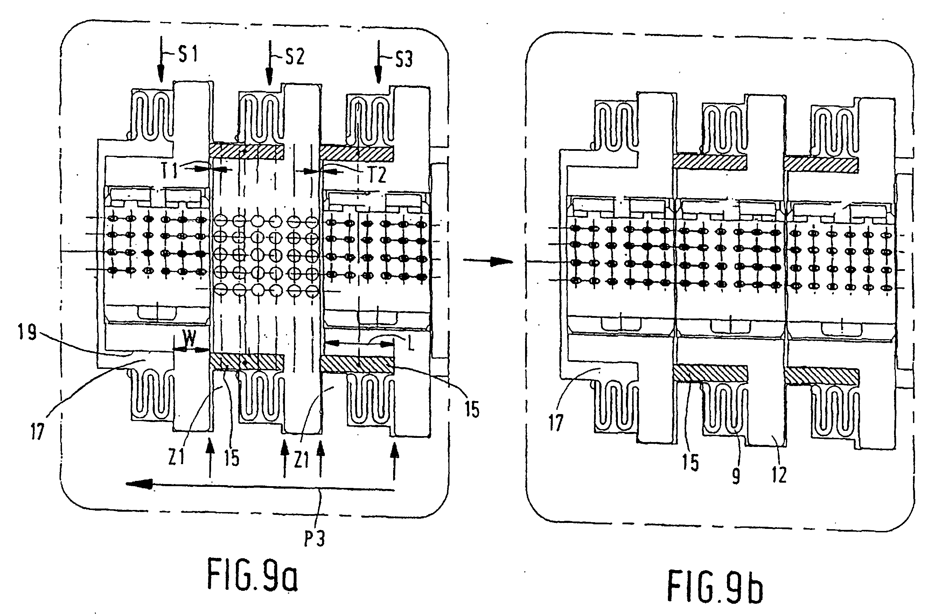

The combined function of the position tool 14 with each segment 7 located in the template 8 is shown by the example in fig. 9a and 9b. In an application requiring end-to-end connector stacking, connector modules 13 have been positioned at the first and third segment positions S1, D3 on template 8. A third module 13 must be located in the second segment position S2 of the template 8. In this case, the position tool 14 with the product 13 is moved towards a specific segment 7 of the template 8. During the downward travel of the position tool 14 loaded with a connector module 13, the four legs 15 with lead-in noses 16 enter four of the openings 17 at two horizontally displaced locations formed between the side edges 19 of the segment 7 and the projections 21 of the template, as shown in fig. 9a. The press-fit terminals 30 enter the holes 11 in the segment 7. The outside edges of legs 15 engage the adjacent segments 7 at the first and third stations S1, S3. This results in a relative movement of the first and second segments 7 and relative movement of both with respect to the third segment 7, in the illustrated case in the direction indicated by arrow P3, to define the desired space to accommodate the plug at the intermediary second location S2 as shown in fig. 9. The distance between the inside and outside edges of each leg 15, i.e., the width of the leg, is dimensioned to be slightly greater than the normal length L (fig. 5b) of the opening 17. As a result, insertion of the legs 15 into the openings 17 move the segments at the first and second locations S1, S2 to create the spaces of dimensions T1 and T2 (fig. 9a). At the same time, the intermediary segment 7 has been precisely positioned with respect to tool 14 by the opposed inside edges of legs 15, that are spaced apart by a distance just slightly greater than the dimension W of the base 12. When the position tool 14 reaches the end of its downward travel, the module 13 has been properly located in the second intermediary space S2, resulting in an arrangement as shown in fig. 9b. With the position tool 14 removed, segments 7 are then free to move back toward each other in a direction opposite to arrow P3 under the action of springs 9. The products 13 can be easily located with relatively inexpensive tooling, at a desired position tolerance, for example, of within ± 0,2 mm at a speed of 1 to 2 sec./product. The movement of segments 7 accommodates side-by-side stacked tolerances of the assembled row of connector modules 13.

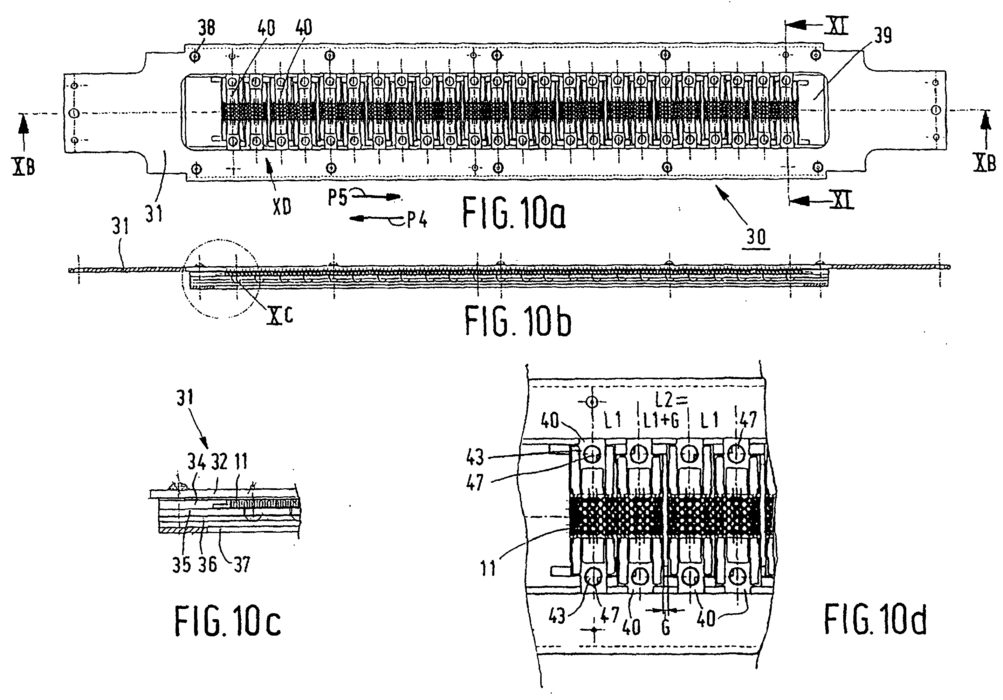

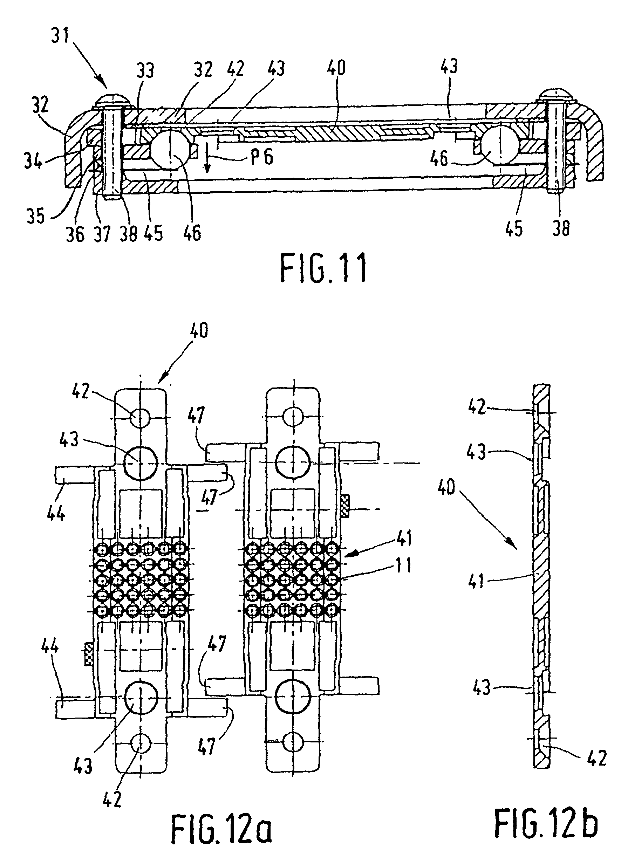

Fig. 10a-d, 11, 12a-b, 13a-d show a second embodiment of a device 30 according to the invention. The device 30 comprises a template 31 built up out of several layers 32-37 which are kept together by means of bolts 38. The layers 32-37 bound an open inner area 39 in which several segments 40 are located in a row at predetermined initial positions. The segments 40 are located between the layers 32, 35 (see fig. 11) preventing the segments 40 from dropping out of the template 30. Each segment 40 comprises an area 41 with the array of holes 11. On both sides of this area 41 the segment 40 has one hole 42 and one opening 43. Near each opening 43 the segment 40 comprises two flanges 44 extending in the direction of the opening 43 of adjacent segment 40. The template 30 is provided with plate springs 45 supporting balls 46 which extend through openings in layer 35. Each segment 40 is located with the holes 42 around the balls 46. The balls 46 determine the initial predetermined position of each segment 40. By the template 30 as shown in fig. 10a-d segments 40 are positioned in sets of two whereby the distance L1 between segments 40 in a set is slightly larger than the dimension of the component to be placed on the segment. The distance L2 between segments 40 of adjacent sets is for example 1 mm larger than the distance L1 causing an air gap G of 1 mm between the segments 40. The flanges 44 of the segments are dimensioned such that by segments 40 lying at a distance L1 of each other the ends 47 of the flanges 44 of one segment 40 extend partly across the opening 43 of the adjacent segment 40 (see fig. 10d).

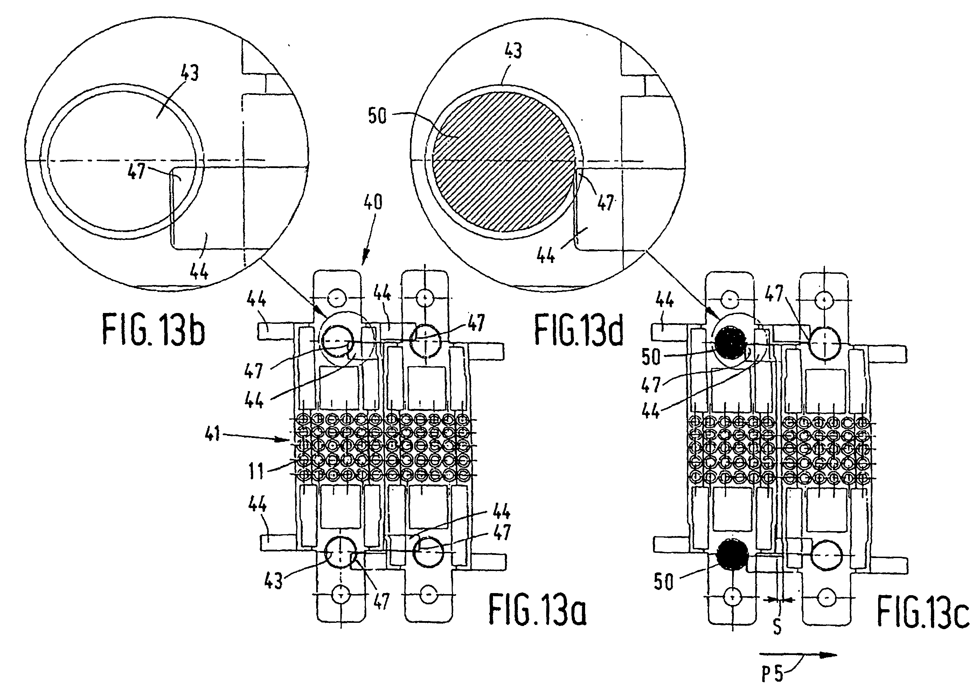

The device also comprises a separate tool (not shown) having two pins 50 (figs. 13c, d) with lead-in sections. The pins 50 are insertable into the two openings 43 of an empty segment 40 into which a component must be placed. If the pins are inserted into these openings 43, the pins will force the flanges 44 of the adjacent segments into opposite directions P4, P5 away from the empty segments 40 making spaces (fig. 13c) for the component to be placed. When the segments 40 are moved into the directions P4 or P5 respectively the balls 46 will be pressed against spring force of the plate 45 into a direction P6. After the component is placed, the tool is removed and under the spring force of the plate springs 45 the balls 46 will be moved back to their initial position whereby also the segments 40 return to their initial predetermined position.

The conveyor 5 comprises a sequential, endless array of templates 8, 31 that are advanced step-wise to the end station 6. Thus each group of connector modules 13 to be received at tool station 6 is pre-assembled on one of the templates 8, 31 of conveyor 5. The positioning tool 14 is a part of the unloading and placing assembly 4 and is movable transversely of the conveyor 5 to position modules at the positions defined by each template 8, 31.

The tooling head 1 at the end station of the configurator C can accurately pick up this array of products for further handling to insert to the printed circuit boards.

The use of a configuration as disclosed lowers product costs by allowing the assembly of standard-sized modules instead of larger mono-block connectors. The configuration can also increase the through-put of application equipment by providing pre-positioned assemblies of connector modules.

The device according to the invention is also suitable for components not having press-fit pins but other means to accurately position them on the segments 40.

## Claims

1. Device for pre-positioning components in a row at predetermined positions for subsequent processing having at least one template and several component receiving segments lying on a row, which are moveable with respect to the template and each other in at least one direction parallel to said row, whilst furthermore comprising at least one component mounting tool to pre-position a component on an empty segment, **characterized in that** said receiving segments (7) lie at predetermined positions on said template (8), whilst furthermore said tool (14) comprises means (15) to relatively move the segments (7) adjacent to said empty segment(7) temporarily during prepositioning (P4,P5) away from said empty segment (7).

2. Device according to claim 1, **characterized in that** each segment (7) is moveable against spring force in two opposite directions.

3. Device according to claim 1 of 2, **characterized in that** each segment (7) is provided with two holes (42) in each of which a ball (46) is located which determine the initial position of the segments (7), each segment (7) is moveable against spring force in the two opposite directions with respect to said balls (46).

4. Device according to claim 3, **characterized in that** the balls (46) are moveable in a direction (P6) extending perpendicular to the direction in which the segments are moveable against spring force.

5. Device according to one of the preceding claims, **characterized in that** several templates (8) are connected to each other to form an endless belt being moveable in a direction perpendicular to the rows of the templates (8).

6. Device according to one of the preceding claims, **characterized in that** each segment (7) is provided with at least one pin receiving opening (43) and at least one flange (44) extending partly over a pin receiving opening of an adjacent segment (7), whilst the tool is provided with at least one pin (50) being insertable into the opening of the segment (7).

7. Device according to claim 6, **characterized in that** the pin (50) is provided with a lead-in portion at one end thereof.

8. Device according to claim 1, **characterized in that** from the initial position in which each segment (7) lies against one edge of the template (8), each segment (7) is moveable against spring force in one direction away from said edge.

9. Method for pre-positioning components in a row at predetermined positions for subsequent processing, whereby components are positioned on segments, which are moveable against spring force, **characterized in that** the segments lie at said predetermined positions on a row, whereby to mount a component on an empty segment(7), the adjacent segments (7) together with the components already mounted thereon are relatively moved away from the empty segment (7) and after mounting of the component on the empty segment (7) and before subsequent processing of said row of components, the adjacent segments (7) are moved back to their initial predetermined position.

## Patentansprüche

1. Vorrichtung zum Vorpositionieren von Bauelementen in einer Reihe an vorgegebenen Positionen für die anschließende Bearbeitung, die wenigstens eine Schablone und mehrere Bauelementaufnahmesegmente, die in einer Reihe liegen und in bezug auf die Schablone und zueinander in wenigstens einer zu der Reihe parallelen Richtung beweglich sind, und ferner wenigstens ein Bauelementmontagewerkzeug für die Vorpositionierung eines Bauelements an einem leeren Segment umfaßt, **dadurch gekennzeichnet, daß** die Aufnahmesegmente (7) an vorgegebenen Positionen auf der Schablone (8) liegen, wobei das Werkzeug (14) ferner Mittel (15) umfaßt, die die an das leere Segment (7) angrenzenden Segmente (7) während der Vorpositionierung (P4, P5) vorübergehend von dem leeren Segment (7) relativ wegbewegen.

2. Vorrichtung nach Anspruch 1, **dadurch gekennzeichnet, daß** jedes Segment (7) in zwei zueinander entgegengesetzten Richtungen entgegen einer Federkraft beweglich ist.

3. Vorrichtung nach Anspruch 1 oder 2, **dadurch gekennzeichnet, daß** jedes Segment (7) mit zwei Löchern (42) versehen ist, wobei sich in jedem dieser Löcher eine Kugel (46) befindet, die die Anfangsposition der Segmente (7) bestimmt, wobei jedes Segment (7) entgegen einer Federkraft in den beiden zueinander entgegengesetzten Richtungen in bezug auf die Kugeln (46) beweglich ist.

4. Vorrichtung nach Anspruch 3, **dadurch gekennzeichnet, daß** die Kugeln (46) in einer Richtung (P6) beweglich sind, die zu der Richtung, in der die Segmente entgegen der Federkraft beweglich sind, senkrecht ist.

5. Vorrichtung nach einem der vorhergehenden Ansprüche, **dadurch gekennzeichnet, daß** mehrere Schablonen (8) miteinander verbunden sind, um einen Endlosriemen zu bilden, der in einer Richtung senkrecht zu den Reihen der Schablonen (8) beweglich ist.

6. Vorrichtung nach einem der vorhergehenden Ansprüche, **dadurch gekennzeichnet, daß** jedes Segment (7) mit wenigstens einer Stiftaufnahmeöffnung (43) und mit wenigstens einem Flansch (44), der sich teilweise über eine Stiftaufnahmeöffnung eines benachbarten Segments (7) erstreckt, versehen ist, während das Werkzeug mit wenigstens einem Stift (50) versehen ist, der in die Öffnung des Segments (7) einschiebbar ist.

7. Vorrichtung nach Anspruch 6, **dadurch gekennzeichnet, daß** der Stift (50) an einem seiner Enden mit einem Einführungsabschnitt versehen ist.

8. Vorrichtung nach Anspruch 1, **dadurch gekennzeichnet, daß** jedes Segment (7) ausgehend von der Anfangsposition, in der jedes Segment (7) an einer Kante der Schablone (8) anliegt, entgegen der Federkraft in einer Richtung weg von dieser Kante beweglich ist.

9. Verfahren zum Vorpositionieren von Bauelementen in einer Reihe an vorgegebenen Positionen für eine anschließenden Bearbeitung, wobei Bauelemente auf Segmenten positioniert werden, die entgegen einer Federkraft beweglich sind, **dadurch gekennzeichnet, daß** die Segmente an den vorgegebenen Positionen in einer Reihe liegen, wobei für die Anbringung eines Bauelements an einem leeren Segment (7) die benachbarten Segmente (7) zusammen mit den bereits darauf montierten Bauelementen von dem leeren Segment (7) relativ wegbewegt werden und wobei nach der Anbringung des Bauelements an dem leeren Segment (7) und vor der anschließenden Bearbeitung der Reihe aus Bauelementen die benachbarten Segmente (7) wieder in ihre anfängliche vorgegebene Position bewegt werden.

## Revendications

1. Dispositif pour pré-positionner des composants sur une rangée en des positions prédéterminées pour un traitement ultérieur, ayant au moins un gabarit et plusieurs segments de réception de composants, alignés en une rangée, qui sont mobiles par rapport au gabarit et les uns par rapport aux autres selon au moins une direction parallèle à ladite rangée, tout en comprenant, en outre, au moins un outil de montage de composants afin de pré-positionner un composant sur un segment vide, **caractérisé en ce que** lesdits segments de réception (7) s'étendent en des positions prédéterminées sur ledit gabarit (8), tandis que, en outre, ledit outil (14) comprend des moyens (15) pour déplacer relativement les segments (7), adjacents audit segment vide (7), temporairement durant le pré-positionnement (P4, P5) afin de les éloigner dudit segment vide (7).

2. Dispositif selon la revendication 1, **caractérisé en ce que** chaque segment (7) est mobile, à l'encontre d'une force d'élasticité, selon deux directions opposées.

3. Dispositif selon la revendication 1 ou 2, **caractérisé en ce que** chaque segment (7) est muni de deux trous (42), dans chacun desquels est disposée une bille (46) qui détermine la position initiale des segments (7), chaque segment (7) étant mobile, à l'encontre d'une force d'élasticité, selon les deux directions opposées par rapport auxdites billes (46).

4. Dispositif selon la revendication 3, **caractérisé en ce que** les billes (46) sont mobiles selon une direction P6 s'étendant perpendiculairement à la direction suivant laquelle les segments sont mobiles à l'encontre d'une force d'élasticité.

5. Dispositif selon une des revendications précédentes, **caractérisé en ce que** plusieurs gabarits (8) sont connectés les uns aux autres afin de former une courroie sans fin mobile selon une direction perpendiculaire aux rangées des gabarits (8).

6. Dispositif selon une des revendications précédentes, **caractérisé en ce que** chaque segment (7) est doté d'au moins une ouverture de réception de broche (43) et d'au moins un rebord (44) s'étendant partiellement par-dessus une ouverture de réception de broche d'un segment (7) adjacent, tandis que l'outil est muni d'au moins une broche (50) susceptible d'être insérée dans l'ouverture du segment (7).

7. Dispositif selon la revendication 6, **caractérisé en ce que** la broche (50) est pourvue d'une partie de guidage d'insertion à une extrémité de celle-ci.

8. Dispositif selon la revendication 1, **caractérisé en ce que,** à partir de la position initiale dans laquelle chaque segment (7) s'étend contre un bord du gabarit (8), chaque segment (7) est susceptible de se déplacer, à l'encontre d'une force d'élasticité, selon une direction l'éloignant dudit bord.

9. Procédé de pré-positionnement de composants sur une rangée en des positions prédéterminées pour un traitement ultérieur, grâce auquel des composants sont positionnés sur des segments, qui sont mobiles à l'encontre d'une force d'élasticité, **caractérisé en ce que** les segments s'étendent auxdites positions prédéterminées sur une rangée, grâce à quoi, pour monter un composant sur un segment vide (7), les segments (7) adjacents, de même que les composants déjà montés sur ceux-ci, sont déplacés relativement pour les éloigner du segment vide (7) et, après un montage du composant sur le segment vide (7) et avant un traitement ultérieur de ladite rangée de composants, les segments (7) adjacents sont déplacés pour les ramener à leur position prédéterminée initiale.
